# EUROPEAN PATENT APPLICATION

(11) **EP 2 253 739 A1**
(43) Date of publication of application: **24.11.2010**
(21) Application number: 09709861.0
(22) Date of filing: 04.02.2009
(51) Int. Cl.: C23F 1/02, C23F 1/18, H05K 3/06

(54) **ETCHING METHOD**

(30) Priority: 12.02.2008 JP 2008030367
(71) Applicant: Mitsubishi Paper Mills Limited, Tokyo 100-0005 (JP)
(72) Inventor: KATO, Makoto, Tokyo 100-0005 (JP); TOYODA, Yuji, Tokyo 100-0005 (JP); NAKAGAWA, Kunihiro, Tokyo 100-0005 (JP); ISHIDA, Mariko, Tokyo 100-0005 (JP)
(74) Representative: Albrecht, Thomas
(86) International application number: PCT/JP2009/052258
(87) International publication number: WO 2009/101948

(57) **Abstract**

Etching is carried out with an etchant that reacts with a metal to be etched to form an insoluble compound. After the etching using the above etchant, etching is carried out using an etchant that does not form an insoluble compound through a reaction with the metal to be etched, whereby the form of an etched portion comes close to a rectangular form, and the side surface of a conductor pattern becomes smooth. Further, after the etching of one surface of a material to be etched is carried out using an etchant that reacts with a metal to be etched to form an insoluble compound nearly from below, the upper and lower sides of the material to be etched is reversed, and the etching of the opposite surface is carried out nearly from below, whereby fine conductor patterns can be formed on both of the surfaces.

## Description

### Technical Field

This invention relates to an etching method to engrave the surface of a metal material.

### Background Art

An etching technique is used as a technique to engrave the surface of a metal material. In particular, in the production of printed wiring boards obtained by forming a conductor pattern containing a metal on an insulating substrate, a subtractive method based on an etching technique is widely used for some reasons including a fast processing speed, which leads to high productivity, and conductor pattern thickness uniformity as compared with other production methods such as an additive method, a semi-additive method, etc.

In the production of a printed wiring board by an etching technique, a material to be etched formed by stacking a metal layer containing a metal to be etched on an insulating substrate with a resist pattern formed on the metal layer is etched, and a conductor pattern is formed. The cross-sectional form of the above conductor pattern frequently comes to be what is called "trapezoidal" in which a top width is smaller than a bottom width (for example, see Printed Circuit Gijutsu Binran, compiled by Japan Institute of Electronics Packaging, issued by Nikkan Kogyo Shimbun, Ltd., May 30, 2006, pages 780-781). When the cross-sectional form of a conductor pattern becomes trapezoidal, there is caused a problem that the area of a surface for mounting parts thereon is deficient or that the wiring resistance increases to increase a transfer loss.

For overcoming the above problems, there is proposed the technique of improving the cross-sectional form of a conductor pattern by selectively removing a metal of a foot with an etchant containing a specific component after etching is finished (for example, see JP 2004-256901A).

The cross-sectional form of a conductor pattern obtained by the technique in JP 2004-256901A is still far from rectangular. Further, there is proposed the technique of using an etchant prepared by adding to an etchant containing copper (II) chloride as a main component a compound that reacts with the ion of a metal to be etched to form a water-insoluble reaction product, such as a benzothiasole (e.g., see JP 6-57453A) and an azole compound having nitrogen alone as a hetero atom (e.g., see Published US Patent Application No. 2005/0016961), etc. However, while a conductor pattern having a top width and a bottom width which are nearly equivalent can be obtained according to the techniques proposed in JP 6-57453A and Published US patent Application No. 2005/0016961, there is still involved a problem that small texture is formed on side surfaces of a conductor pattern and the transfer loss is increased due to a conductor skin effect when it is used in a high-frequency circuit.

Further, when a double-sided printed wiring board is produced, conventionally, etching is applied simultaneously to both the upper and lower surfaces of a material to be etched obtained by forming metal layers containing a metal to be etched on both the surfaces of an insulating substrate with resist patterns formed on the metal layers. When this method is used, however, there is a problem that the surface to be etched as the upper surface has a difficulty in forming a fine conductor pattern as compared with the surface to be etched as the lower surface (see the paper entitled "High-precision Etching Conditions in Continuous Circuit-Formation Method", authored by Koji SATO and Shuji KITAGAWA, Matsushita Electric Works Technical Report, Matsushita Electrics Works, Ltd., August 2001, No. 75, pages 44-50). While one surface (surface A) of a material to be etched is etched with the one surface (surface A) being a lower surface, the surface (surface B) as an upper surface opposite to the surface A is kept from contacting an etchant, and after the etching of the surface A is finished, the upper and lower sides of the material to be etched are reversed, and the surface B as a lower surface is etched while the upper surface is kept from contacting an etchant, whereby fine patterns can be formed on both the surfaces. However, it requires a special method to keep the upper surface from contacting an etchant. For example, it is required to secure a sufficient margin in the circumference of a material to be etched in order to prevent that an etchant flowing around onto the upper surface etches a necessary portion, it is required to use an etching apparatus having a complicated mechanism for preventing an etchant from flowing around onto the upper surface (for example, see JP 5-226809A and JP 6-302935A), or it is required to use an etching apparatus having a suction device for removing an etchant from the upper surface (for example, see Published US Patent Application No. 2003/0150381). In these methods, however, there is involved a problem that a portion of a material which forms the margin goes to waste, or that the etching apparatus is so complicated that its maintenance is troublesome.

As means for solving the above problems, there can be possibly employed a constitution in which a protective layer is formed on the surface B to be etched later, the surface A is etched from below, then, the protective layer is removed from the surface B, a protective layer is formed on the surface A, the upper and lower sides are reversed, and the surface B is etched from below. However, the step of forming the protective layer and the step of separating it need to be carried out twice each, and there is a problem that the production process is very complicated.

### Summary of the Invention

### Problems to be Solved by the Invention

The first object of this invention is to provide an etching method for producing a conductor pattern having a nearly rectangular cross-sectional form and smooth side surfaces. The second object of this invention is to provide an etching method in which conductor patterns can be formed on both two surfaces of a material to be etched without any complicated apparatus or steps.

### Means to Solve the Problems

The first etching method of this invention is a method for etching a material to be etched prepared by forming a resist pattern on a metal layer containing a metal to be etched, the method comprising consecutively carrying out the steps of (1) ejecting an etchant containing a compound that reacts with the metal to be etched to form a water-insoluble reaction product, by means of a spray nozzle, to perform etching until the etching depth reaches 60 % or more of the metal layer thickness, and (2) ejecting an etchant which does not form any water-insoluble reaction product through a reaction with the metal to be etched, by means of a spray nozzle, to perform etching.

In the first etching method of this invention, when the metal to be etched is immersion-etched with the etchant to be used in the step (2), the etching speed is preferably 0.3 µm/minute or more but 3 µm/minute or less.

In the first etching method of this invention, preferably, the metal to be etched is copper or copper alloy, and the etchant for use in the step (1) is an etchant containing iron (III) chloride and oxalic acid. Further, preferably, the metal to be etched is copper or copper alloy, and the etchant for use in the step (2) is an etchant containing iron (III) chloride or copper (II) chloride.

In the first etching method of this invention, preferably, the step (3) of removing the above water-insoluble reaction product with a liquid that dissolves the above water-insoluble reaction product is carried out between the step (1) and the step (2). Further, more preferably, the metal to be etched is copper or copper alloy and the etchant for use in the step (2) is an etchant containing copper (II) chloride.

The second etching method of this invention is an etching method for etching a material to be etched which material is obtained by stacking metal layers each containing a metal to be etched on both surfaces of an insulating material and forming resist patterns on the metal layers, the method comprising consecutively carrying out the three steps of (4) holding the material to be etched horizontally or at an angle of 20° or less from the horizontal and ejecting an etchant that reacts with the metal to be etched to form a water-insoluble reaction product, by means of a spray nozzle from below the material to be etched, to etch one surface (surface A) of the material to be etched, (5) reversing the upper and lower sides of the material to be etched, and (6) holding the material to be etched horizontally or at an angle of 20° or less from the horizontal and ejecting the etchant that reacts with the metal to be etched to form a water-insoluble reaction product, by means of a spray nozzle from below the material to be etched, to etch that surface (surface B) which is opposite to the surface (A).

In the second etching method of this invention, preferably, the metal to be etched is copper or copper alloy, the etchant containing the compound that reacts with ion of the metal to be etched to form a water-insoluble reaction product is an etchant containing iron (III) chloride and oxalic acid.

Further, in the second etching method of this invention, preferably, the step (7) of removing the above water-insoluble reaction product with a liquid that dissolves the above water-insoluble reaction product is carried out between the step (4) and the step (6).

### Effect of the Invention

By the first etching method of this invention, there can be obtained a conductor pattern having a nearly rectangular cross-sectional form and smooth side surfaces. By the second etching method of this invention, fine patterns can be formed on both the surfaces of a material to be etched, without using complicated apparatus or steps.

### Brief Description of Drawings

Fig. 1 is a schematic cross-sectional view of a conductor pattern formed by an etching method.
Fig. 2 is a schematic cross-sectional view of a concave portion (narrowed part) that can occur on a side surface of a conductor pattern.
Fig. 3 is a schematic cross-sectional view showing a preferred positional relationship between a plate-shaped work and a spray nozzle.
Fig. 4 is a schematic cross-sectional view showing a preferred positional relationship between a plate-shaped work and a spray nozzle.

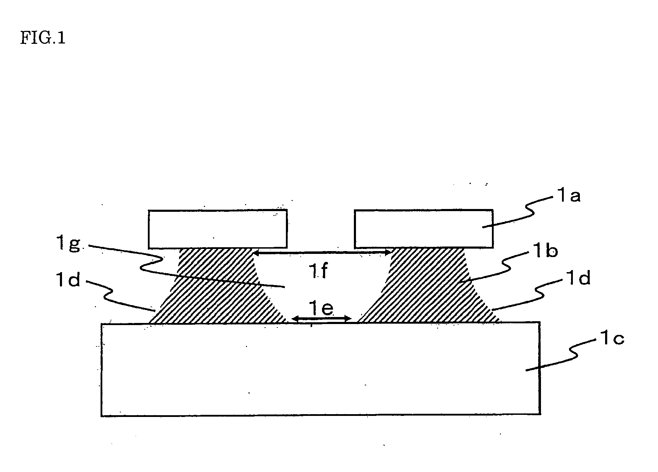

Reference numerals in Figs. 1 to 4 will be explained below.
- 1a: Resist pattern
- 1b: Metal layer
- 1c: Substrate
- 1d: Side surface
- 1e: Bottom space width
- 1f: Top space width
- 1g: Etched portion
- 2a: Concave portion (narrowed portion) formed on side surface of conductor pattern
- 2b: Upper end portion of narrowed portion
- 2c: Deepest portion of narrowed portion
- d: Depth of narrowed portion 2a
- 3a: Material to be etched
- 3b: Spray nozzle
- P: Perpendicular line to etching surface, projected on a vertical plane in parallel with a conveying direction
- C: Ejection center axis of spray nozzle, projected on a vertical plane in parallel with a conveying direction
- x: Angle formed by P and C
- P': Perpendicular line to etching surface, projected on a vertical plane perpendicular to a conveying direction
- C': Ejection center axis of spray nozzle, projected on a vertical plane perpendicular to a conveying direction
- y: Angle formed by P' and C'

### Embodiment for Practicing the Invention

The first etching method of this invention (To be referred to as "first etching method" hereinafter) will be explained.

Fig. 1 shows a schematic cross-sectional view of a conductor pattern formed by an etching method. A conductor pattern of a metal layer 1b is formed on a substrate 1c, and the 1a indicates a resist pattern used during etching. The portion of a space (dent) formed by etching the metal layer 1b by an etching method will be an "etched portion" 1g. In the first etching method of this invention, there are consecutively carried out the steps of (1) ejecting an etchant that reacts with the metal to be etched to form a water-insoluble reaction product, by means of a spray nozzle, to perform etching until the etching depth reaches 60 % or more of the metal layer thickness, and (2) ejecting an etchant that does not react with the metal to be etched and hence does not form a water-insoluble reaction product through a reaction with the metal to be etched, by means of a spray nozzle, to perform etching, whereby the top space width 1f and bottom space width 1e of the etched portion come to be closely equivalent, so that a conductor pattern having a nearly rectangular cross-sectional form can be obtained. The method of ejecting an etchant with a spray nozzle will be referred to as a spray method.

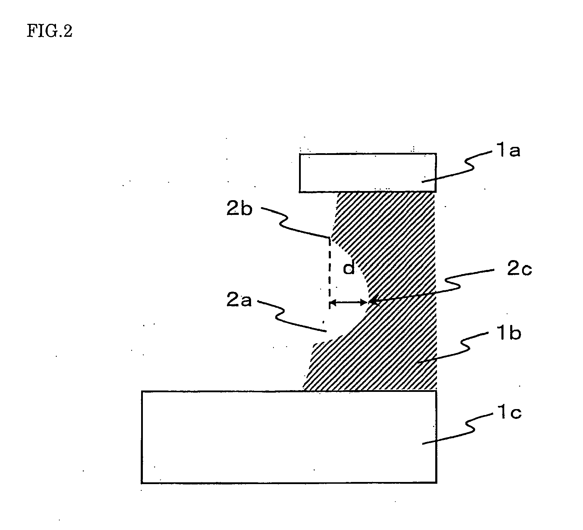

In the step (1), in the etched portion 1g, the etching proceeds while a water-insoluble reaction product is deposited in a portion where the flow speed of the etchant is low. In the portion covered with the deposited water-insoluble reaction product, the etching proceeds extremely slowly, and in an early stage of the step (1), the water-insoluble reaction product easily adheres to a portion that keeps the etching from proceeding in the lateral direction, so that the etching mainly proceeds only in the depth direction. However, as the step (1) is proceeded with, the etching in the lateral direction comes to proceed at a certain speed. In particular, as shown in Fig. 2, around the middle portion along the metal layer thickness in the etched portion 1g, a concave portion (narrowed portion) 2a is liable to occur on a side surface 1d of the etched portion 1g. Further, since the above water-insoluble reaction product is deposited non-uniformly to some extent, small texture is sometimes formed on the side surface 1d of the etched portion to give a surface in a roughened state. In this invention, the narrowed portion 2a and small texture formed in the step (1) can be removed by the etching in the step (2). Therefore, there can be obtained a conductor pattern having a nearly rectangular cross-sectional form and smooth surfaces. By the above technique, there can be produced a printed wiring board that is suitable for transmitting high-frequency current.

In the first etching method, as the etching depth in the step (1) is smaller, the cross-sectional form is more liable to become trapezoidal, and as the etching depth in the step (1) is larger, the etching form is more liable to become rectangular. That is, in the first etching method of this invention, the cross-sectional form obtained after completion of the step (2) can be controlled by adjusting the etching depth provided in the step (1). This relationship will be specifically explained below.

When the etching in the step (1) is carried out until the etching depth becomes 60 % or more but less than 90 % of the metal layer thickness, and further when the etching in the step (2) is carried out until a desired bottom space width is obtained, it comes to be easier to obtain a trapezoidal conductor pattern having a top space width 1f and a bottom space width 1e closer to each other in size than that in a conventional etching technique and having a cross-sectional form closer to a rectangular form than that in a conventional etching method. When the cross section of a conductor pattern has the above form, the conductor pattern is inferior to some extent from the viewpoint of satisfaction of both high insulation reliability and low conductor resistance when compared with a conductor pattern having a rectangular cross-sectional form, while there is an advantage that the quality control of the conductor pattern can be performed by observation from above like a conductor pattern produced by a conventional etching method.

When the etching in the step (1) is carried out until the etching depth becomes 90 % or more but 100 % or less of the metal layer thickness, and further when the etching in the step (2) is carried out until a desired bottom space width is obtained, the cross-sectional form of a conductor pattern can be made far closer to a rectangular form. Alternatively, when the etching in the step (1) is carried out for a time period that is 1 to 1.1 times the time period required until the etching depth becomes equivalent to the metal layer thickness, and when, further, the etching in the step (2) is carried out until a desired bottom space width is obtained, the cross-sectional form of a conductor pattern can be made far closer to a rectangular form.

When the etching in the step (1) is carried out for a time period that is more than 1.1 times the time period required until the etching depth becomes equivalent to the metal layer thickness, and further, when the etching in the step (2) is carried out until a desired top space width 1f is obtained, there can be obtained a conductor pattern having a reversed trapezoidal form having a narrow top space width 1f and a wide bottom space width 1e.

In any one of these cases, it is required to adjust the etching depth provided by the etching in the step (1) in the above range in order to obtain a desired form.

In the first etching method, further, when the etchant for use in the step (2) has a faster etching speed, there is also an advantage that the etching can be completed in a shorter period of time in terms of a total time period of the steps (1) and (2) as compared with the case of one-step etching with using only one etchant for use in the step (1).

In the first etching method, the material to be etched refers to a material obtained by forming a resist pattern on a metal layer containing a metal to be etched. When a printed wiring board is produced, there is used a material obtained by stacking metal layer(s) on one surface or both surfaces of a substrate and forming resist pattern(s) on the metal layer(s).

As a substrate that can be used for producing a printed wiring board, there can be used various synthetic resins such as an epoxy resin, a phenolic resin, a melamine resin, a polyester resin, a polyimide resin, a polyamide resin, a fluororesin, etc., fiber-reinforced resins obtained by impregnating fibers such as paper and a glass fiber, etc., with these synthetic resins, such as paper phenol, paper epoxy, glass epoxy, etc., and various glasses, ceramics and metals. When a printed wiring board is produced, fiber-reinforced resins, heat-resistant resins such as a polyimide, a fluororesin, etc., and ceramics are preferably used from the viewpoint of insulating properties, mechanical properties, heat resistance, etc. There can be also used a substrate obtained by compounding or stacking two or more materials.

The metal to be etched refers to a metal material that is removed by etching. The metal to be etched can be selected from various metals such as copper, copper alloy, aluminum, tin, etc. When a printed wiring board is produced, copper or copper alloy is preferably used from the viewpoint of conductivity, mechanical properties, soldering properties, etc.

The method for stacking the metal layer on the substrate is not specially limited, and the substrate and a metal foil can be bonded to each other with a phenol-, melamine-, epoxy-, urethane-, silicon- or modified silicon-containing adhesive, any one of adhesives containing various rubbers such as chloroprene, nitrile and acrylic rubbers, or a vinyl-acetate-containing adhesive. Further, a metal foil can be also stacked on the substrate by a so-called heat-seal method. There can be also employed a so-called casting method in which a heat-melted product or solution of a material for forming a substrate is applied onto a metal foil and the applied material is cooled or dried to solidify to form a laminate. There can be also used a laminate produced by forming a metal layer on the surface of a substrate by electric plating, electroless plating or a vacuum vapor deposition method such as sputtering, etc.

The method for forming a resist pattern is not specially limited, and it can be selected from various methods such as a photolithography method, a screen printing method, etc. Of these methods, the photolithography method is preferably used, since a fine pattern can be easily formed. As a resist for use in the photolithography method, there can be used both a negative photoresist in which a portion other than a portion insolubilized by exposure to light is removed by dissolving it with an alkali aqueous solution, etc., and a positive photoresist in which a portion solubilized by exposure to light is removed by dissolving it with an alkali aqueous solution, etc., while the positive photoresist is particularly preferred since no spreading bottom of a line portion is easily formed so that a highly reliable printed wiring board can be produced. In addition, in the second etching method, the resist used on the surface A and the resist used on the surface B may be the same or may be different.

The etchant refers to a liquid that dissolves a metal to be etched, at a processing-wise reasonable speed, that is, at a speed of 0.1 µm/minute or more under processing conditions where the etchant is applied. Further, the etchant contains a component that dissolves a metal to be etched (to be referred to as "etching component" hereinafter). Examples of the etching component that is used when the metal to be etched is copper or copper alloy include iron (III) chloride, copper (II) chloride, a sulfuric acid-hydrogen peroxide mixture, persulfate, etc.

In the step (I), there is used an etchant that reacts with a metal to be etched to form a water-insoluble reaction product. The etchant in the step (1) contains in addition to the etching component a compound that is capable of reacting with ion of the metal to be etched to form a water-insoluble reaction product. In this invention, the "compound that reacts with ion of the metal to be etched to form a water-insoluble reaction product" is added mainly for the purpose of improving the cross-sectional form of a conductor pattern such that it is closer to the form of a rectangle, and will be described as "form improver". A water-insoluble reaction product formed by a reaction between the ion of a metal to be etched and the form improver will be described as "water-insoluble reaction product". The content of the form improver can be any amount if it is sufficient for forming a water-insoluble reaction product on the surface of the metal to be etched (including side surfaces of an etched portion).

As the etchant in the step (2), there is used an etchant that does not form a water-insoluble reaction product through a reaction with the metal to be etched.

The etching component in the etchant in the step (1) and the etching component in the etchant in the step (2) may be the same or may be different. The etchant for use in the step (2) may contain a small amount of a form improver so long as the water-insoluble reaction product does not remain on the surface of a metal to be etched (including side surfaces of the etched portion). Therefore, it is preferred, but is not essential, to keep the form improver from being contained in the etchant in the step (2) by carrying out the procedures of liquid removal or rinsing with water between the step (1) and the step (2) so that the etchant in the step (1) is kept from being included in the etchant in the step (2).

When the metal to be etched is copper or copper alloy, examples of the form improver include oxalic acid and various azole compounds proposed in JP 6-57453A and Published US Patent Application No. 2005/0016961.

In the first etching method, when the metal to be etched is copper or copper alloy, the etchant in the step (1) preferably contains 1 to 20 mass% of iron (III) chloride as an etching component and 5 to 50 mass%, based on the iron (III) chloride, of oxalic acid as a form improver. When the above etchant is used, there can be easily obtained a conductor pattern having an etched portion in which the top space width 1f and the bottom space width 1e are very close to each other and having a cross-sectional form close to a rectangular form.

In the first etching method, when the metal to be etched is copper or copper alloy, an aqueous solution containing iron (III) chloride or copper (II) chloride as an etching component is preferably used as the etchant in the step (2). And, it is particularly preferred to use an aqueous solution containing copper (II) chloride. These etching components have lower concentrations that are required for obtaining certain constant etching speeds than other etching components, so that their viscosities are low when compared on the basis of the constant etching speeds. As a result, etching uniformly proceeds even in a fine etched portion, and a good cross-sectional form closer to a rectangular form can be obtained. Further, when copper (II) chloride is used as the etchant in the step (2), there is also another advantage that side surfaces of a conductor pattern can be made remarkably smooth.

For obtaining an etching form that is very close to a rectangular form in the first etching method, it is preferred to use an etchant having an etching speed of 0.3 µm/minute or more but 3 µm/minute or less in the step (2) when a metal to be etched is immersion-etched in the etchant (the above etching speed will be referred to as "immersion-etching speed" hereinafter). That is because when such an etchant is used, the top portion and bottom portion of a conductor pattern are etched at equivalent speeds, so that an etching form closer to a rectangular form can be obtained. When the etching speed in the immersion etching is larger than 3 µm/minute, the difference in the etching speed in the top portion and that in the bottom portion becomes large, so that the top space width 1f tends to be large and that the bottom space width 1e tends to be small. When the etching speed in the immersion etching is smaller than 0.3 µm/minute, the improvement effect on the roughness of side surfaces 1d of a conductor pattern may decrease.

As an etchant having an etching speed of 0.3 µm/minute or more but 3 µm/minute or less when a metal to be etched is immersion-etched, there is used an etchant of which the etching component concentration is adjusted as required. For example, when the metal to be etched is copper or copper alloy, there is employed an etchant containing 0.2 to 3 mass% of iron (III) chloride and 0.2 to 2 mass% of hydrogen chloride or an etchant containing 0.5 to 8 mass% of copper (II) chloride and 1 to 5 mass% of hydrogen chloride.

In the first etching method, the etched portion after the step (2) is carried out may sometimes have a narrowed portion remaining. This problem is caused because a water-insoluble reaction product in a narrowed portion is removed faster to make the etching proceed non-uniformly in the initial stage of the etching in the step (2), so that the function of removing the narrowed portion is decreased. For getting around the above problem, it is sufficient to take the step of removing the water-insoluble reaction product prior to the step (2). Specifically, the step (3) of removing a water-insoluble compound with a liquid that dissolves the water-insoluble reaction product is carried out between the step (1) and the step (2). As a liquid in the step (3), an aqueous solution containing a chemical agent that dissolves the water-insoluble reaction product can be used. Naturally, when the metal to be etched is dissolved in the step (3), the above effect is no longer obtained. Therefore, the liquid that is used in the step (3) to dissolve the water-insoluble reaction product is required to be a liquid that dissolves the metal to be etched, at a slow speed of less than 0.3 µm/minute even if it dissolves the metal to be etched, and most preferably, the liquid does not at all dissolve the metal to be etched.

The chemical agent that dissolves the water-insoluble reaction product can be selected as required depending upon kinds of the water-insoluble reaction product, while it is selected from monovalent acids such as hydrochloric acid, amidosulfuric acid, acetic acid, etc., hydroxy acids such as citric acid, gluconic acid, etc., or chelating agents such as ethylenediamine tetraacetic acid salt, etc. Preferably, these chemicals dissolve the water-insoluble reaction product as rapidly as possible.

In the first etching method, when the metal to be etched is copper or copper alloy, an aqueous solution containing hydrochloric acid is particularly preferably used as a liquid in the step (3). Further, the above liquid is preferably warmed before used, since the dissolving speed of the water-insoluble reaction product is increased. The method for applying the above liquid to a material be etched can be selected from various methods such as a spray method, an immersion method, a paddle method, etc. The spray method is preferred owing to advantages that the movement of the liquid to fine concave regions on the surface of the material to be etched is rapidly carried out so that a water-insoluble reaction product can be dissolved fastly and that the apparatus can be downsized.

As mentioned above, when the metal to be etched is copper or copper alloy, particularly preferably, an etchant containing copper (II) chloride as an etching component is used, since the side surfaces of an etched portion become very smooth. However, when the etchant containing copper (II) chloride as an etching component is used, the solubility of the water-insoluble reaction product is low, and in many cases, the step (2) takes a long time, or a narrowed portion remains in the side surface of a conductor pattern. When the metal to be etched is copper or copper alloy and when an etchant containing copper (II) chloride as an etching component is used in the step (2), it is particularly effective to carry out the step (3) between the step (1) and the step (2).

The second etching method of this invention (to be referred to as "second etching method" hereinafter) will be explained.

In the second etching method, the etching material refers to a material obtained by stacking metal layers containing a metal to be etched each on both surfaces of an insulating substrate and forming resist patterns on the metal layers.

The substrate can be selected from various synthetic resins such as an epoxy resin, a phenolic resin, a melamine resin, a polyester resin, a polyimide resin, a polyamide resin, a fluororesin, etc., fiber-reinforced resins obtained by impregnating fibers such as paper and a glass fiber, etc., with these synthetic resins, such as paper phenol, paper epoxy, glass epoxy, etc., and various glasses, ceramics and metals. When a printed wiring board is produced, a fiber-reinforced resin, heat-resistant resins such as a polyimide, a fluororesin, etc., and ceramics are suitably used from the viewpoint of insulating properties, mechanical properties, heat resistance, etc. There can be also used a substrate obtained by compounding or stacking two or more materials.

The metal to be etched refers to a metal material that is removed by etching. The metal to be etched can be selected from various metals such as copper, copper alloy, aluminum, tin, etc. When a printed wiring board is produced, copper or copper alloy is preferably used from the viewpoint of conductivity, mechanical properties, soldering properties, etc.

The method for stacking the metal layers on the substrate is not specially limited, and the substrate and metal foils can be bonded with a phenol-, melamine-, epoxy-, urethane-, silicon- or modified silicon-containing adhesive, any one of adhesives containing various rubbers such as chloroprene, nitrile and acrylic rubbers, or a vinyl-acetate-containing adhesive. Further, metal foils can be also stacked on the substrate by a so-called heat-seal method. There can be also employed a so-called casting method in which a heat-melted product or solution of a material for forming a substrate is applied onto a metal foil and the applied material is cooled or dried to solidify to form a laminate. There can be also used a laminate produced by forming a metal layer on each surface of a substrate by electric plating, electroless plating or a vacuum vapor deposition method such as sputtering, etc.

The method for forming a resist pattern is not specially limited, and it can be selected from various methods such as a photolithography method, a screen printing method, etc. Of these methods, the photolithography method is preferably used, since a fine pattern can be easily formed. As a resist for use in the photolithography method, there can be used both a negative photoresist in which a portion other than a portion insolubilized by exposure to light is removed by dissolving it with an alkali aqueous solution, etc., and a positive photoresist in which a portion solubilized by exposure to light is removed by dissolving it with an alkali aqueous solution, etc., while the positive photoresist is particularly preferred since the bottom of a line portion is hardly spread, so that a highly reliable printed wiring board can be produced. In addition, in the second etching method, the resist used on the surface A and the resist used on the surface B may be the same or may be different.

In the second etching method, characteristically, the surface A is etched in the step (4) first, then the material to be etched is reversed in the step (5), and then the surface B is etched in the step (6). The resist pattern on the surface B may be formed at any time before the step (6) of etching the surface B, while the surface B may be sometimes affected by an etchant that moves around onto the surface B during the etching of the surface A, and the adhesion of a resist material to the surface B may be deteriorated, so that it is preferred to form the resist pattern on the surface B before the etching of the surface A. The resist pattern on the surface A may be removed after completion of the etching of the surface B, or may be removed before the etching of the surface B. However, when the resists on the surface A and the resist on the surface B can be removed by the same method, it is preferred to remove the resists on the two surfaces together after completion of the etching of the surface B from the viewpoint of efficiency. Further, in case that a resist pattern on the surface A remains when the surface B is etched, advantageously, a microscopic morphological change does not take place on the surface A.

In the second etching method, there is used an etchant that reacts with the metal to be etched to form a water-insoluble reaction product like the etchant used in the step (1) of the first etching method.

Such an etchant has the property of dissolving the metal to be etched when it flows at a relatively fast speed but dissolving almost no metal to be etched when it stands still or flows at a slow speed. When the lower surface is etched with a spray etching apparatus, the etchant inevitably moves around on the upper surface of a material to be etched, while the flow of the etchant on the upper surface of the material to be etched is extremely slow as compared with the flow of the etchant on the lower surface, so that the etchant that moves around onto the upper surface hardly dissolves the upper surface and changes the form of the upper surface. When such an etchant is used, therefore, both surfaces of the material to be etched can be spray-etched from below without using any complicated apparatus or steps, and fine conductor patterns can be formed on both surfaces by an etching method.

In the second etching method, when the metal to be etched is copper or copper alloy, it is preferred to use an etchant containing 1 to 20 mass% of iron (III) chloride as a main effective component and 5 to 100 mass%, based on the iron (III) chloride, of oxalic acid as a form improver. That is because the above etchant has a great difference between the speed of dissolving the metal to be etched in a flowing state and the speed of dissolving the metal to be etched in a standing state and hence make it possible to remarkably reduce the change of form of the upper surface during the etching of the lower surface.

In the second etching method, it is the most preferred to hold the material to be etched horizontally for reliably producing a fine conductor pattern, while the effect of this invention can be produced so long as it is held in a nearly horizontal state. Specifically, all that is required of the angle that is to be formed by the etching surface of the material to be etched and the horizontal is 20° or less, and it is more preferably 10° or less, still more preferably 5° or less.

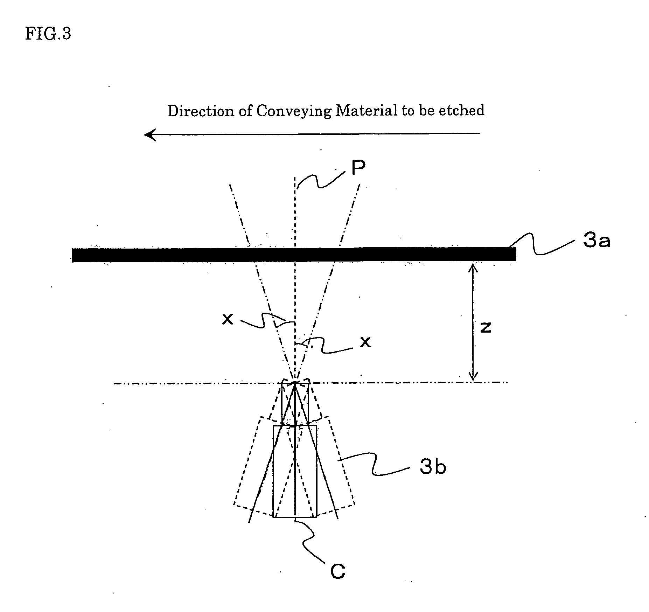

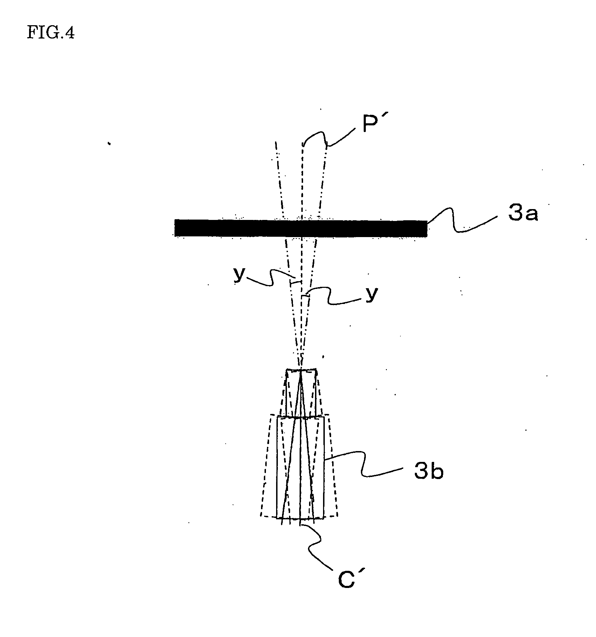

In the second etching method, it is required to eject the etchant to the material to be etched, from below with a spray nozzle. Figs. 3 and 4 are schematic cross-sectional views showing a positional relationship of the material to be etched and the spray nozzle. In Fig. 3, the material to be etched is conveyed from right to left. In Fig. 4, the material to be etched is conveyed from front to back. In Fig. 3, the angle x formed by a perpendicular line P perpendicular to the direction in parallel with the carrying direction and downward from the material 3a to be etched and the center line C of the spray nozzle is preferably 45° or less, particularly preferably 20° or less. In Fig. 4, further, the angle y formed by a perpendicular line P' perpendicular to the direction at right angles with the carrying direction and downward from the material 3a to be etched and the center line C' of the spray nozzle is preferably 30° or less, more preferably 10° or less, still more preferably 5° or less. When the center axis of the spray nozzle is out of these ranges, the etching may proceed non-uniformly, or a pattern formed after the etching may not be a faithful reproduction of a resist pattern.

In the second etching method, the pressure (gauge pressure) for supplying a liquid to the spray nozzle is preferably adjusted to 50 to 500 kPa. When the supply pressure is lower than the above, the difference between the speed of dissolving the metal to be etched by an etchant that moves around onto the upper surface during the etching of the lower surface and the speed of dissolving on the lower surface is small, and the form of the upper surface may be sometimes changed during the etching of the lower surface.

In the second etching method, a water-insoluble reaction product may be sometimes formed on part or the whole of the surface B by an etchant that moves around onto the surface B during the etching of the surface A. As a result, the etching of the surface B may take a long time, or there may be sometimes a difference in etching completion between a region where the water-insoluble reaction product is formed and a region where it is not formed. For getting around the above problem, the step (7) of removing the water-insoluble reaction product can be carried out between the step (4) of etching the surface A and the step (6) of etching the surface B. Specifically, it is sufficient to carry out the step of washing with an aqueous solution containing a chemical agent that dissolves the water-insoluble reaction product between the step (4) and the step (6). The above chemical agent that dissolves the water-insoluble reaction product can be selected from like chemical agents which are used for the treatment to remove the water-insoluble reaction product in the step (3) of the first etching method. For example, it can be selected from monovalent acids such as hydrochloric acid, amidosulfuric acid, acetic acid, etc., hydroxy acids such as citric acid, gluconic acid, etc., or chelating agents such as ethylenediamine tetraacetic acid salt, etc.

Since the material that has been etched has a water-insoluble reaction product adhering thereto, it is preferred to carry out the procedure of removing the water-insoluble reaction product from both surfaces after the etching of the surface B. For this procedure, it is sufficient to carry out the step of washing with an aqueous solution containing a chemical agent that dissolves the water-insoluble reaction product like the step (7).

The second etching method is suitably applied to the production of a double-sided printed wiring board, while it can be also used as part of the steps of producing a printed wiring board having three or more conductor layers.

### Examples

Examples 1 to 11 are examples of the first etching method.

### Example 1

### <Preparation of material to be etched>

A positive liquid resist was applied to a copper-clad laminate obtained by stacking a 40 µm thick polyimide insulating substrate and a 18 µm thick electro-deposited copper foil (metal layer), and the positive liquid resist was dried such that a dried resist layer had a thickness of 5 µm. The resist was exposed through an evaluation pattern having a line width/space width of 25 µm/25 µm, followed by development and washing with water, to form a resist pattern, whereby a material to be etched for etching test was prepared.

### <Preparation of etchant for step (1)>

Water was added to 6.0 kg (2.22 kg as iron chloride anhydride) of a commercially available 40°Be iron (III) chloride aqueous solution (concentration 37 mass%) and 0.25 kg (0.18 kg as oxalic acid anhydride) of oxalic acid dihydrate up to a total of 30 kg to prepare 30 kg of an etchant containing 7.4 mass % of iron (III) chloride and 0.60 mass% of oxalic acid.

### <Step (1)>

The above etchant for the step (1) was ejected to the material to be etched, with a spray-etching apparatus (trade name: YCE-85III, supplied by YAMAGATA MACHINERY CO., LTD.) at a spray pressure of 200 kPa until an etching depth of 16 µm (89 % of electro-deposited copper foil thickness) was reached. The material to be etched was washed with water immediately after being etched. The time period for the above etching was 70 seconds. When the material to be etched after it was washed with water was observed through an optical microscope, there was observed a pale greenish crystal (water-insoluble reaction product) that adhered to side surfaces of the etched portion.

### <Preparation of etchant for step (2)>

Water was added to 0.080 kg (0.030 kg as iron chloride anhydride) of a commercially available 40°Be iron (III) chloride aqueous solution (concentration 37 mass%) and 0.60 kg (0.21 kg as hydrogen chloride) of hydrochloric acid having a concentration of 36 mass% up to a total of 30 kg to prepare 30 kg of an etchant containing 0.10 mass% of iron (III) chloride and 0.72 mass% of hydrogen chloride. When the above copper-clad laminate having no resist pattern was immersed in this etchant, copper on the surface was dissolved in 90 minutes, and the polyimide as the substrate was exposed. Therefore, the immersion-etching speed of this etchant for the step (2) was 0.2 µm/minute.

### <Step 2>

The material to be etched, after the step (1), was etched with the above etchant for the step (2) until the bottom space width 1e of the etched portion became 25 µm which was the same as the space width of the resist pattern (etching time period 75 seconds). The etched material was washed with water immediately after being etched. For conditions such as an etching apparatus, a spray pressure, etc., the same conditions as those in the step (1) were employed. When the etched material after it was washed with water was observed through an optical microscope, there was observed no water-insoluble reaction product that adhered to side surfaces of the etched portion.

### <Post treatment>

The etched material after the end of the step (2) was immersed in an aqueous sodium hydroxide solution having a concentration of 3.0 mass% for 3 minutes to peel off the resist pattern, and then hydrochloric acid having a hydrogen chloride concentration of 3.6 mass% was ejected with a spray nozzle for 30 seconds to clean it, followed by washing with water and drying, whereby a printed wiring board for evaluation was produced.

### Examples 2 - 5

Printed wiring boards for evaluation were produced in the same manner as in Example 1 except that the composition of the etchant for the step (2) was changed as shown in Table 1. In addition, when each of etched materials of these Examples was observed through an optical microscope after the end of the step (2), there was observed no water-insoluble reaction product that adhered to side surfaces of the etched portion.

### Examples 6 - 9

Printed wiring boards for evaluation were produced in the same manner as in Example 1 except that the step (3) of cleaning the material to be etched with hydrochloric acid having a hydrogen chloride concentration of 3.6 mass% for 30 seconds by means of the same spray-etching apparatus as that used in the step (1) was carried out between the step (1) and the step (2) and that the composition of the etchant for the step (2) was changed as shown in Table 1. When each of etched materials of these Examples was observed through an optical microscope after the end of the step (2), there was observed no water-insoluble reaction product that adhered to side surfaces of the etched portion.

### Example 10

A printed wiring board for evaluation was produced in the same manner as in Example 8 except that the step (1) was carried out until an etching depth of 11 µm (61 % of thickness of an electro-deposited copper foil) was reached.

### Example 11

A printed wiring board for evaluation was produced in the same manner as in Example 8 except that an aqueous sodium persulfate solution having a concentration of 10 mass% was used as an etchant for the step (2). When the etched material of this Example was observed through an optical microscope after the end of the step (2), there was observed no water-insoluble reaction product that adhered to side surfaces of the etched portion.

### Example 12

A printed wiring board was produced in the same manner as in Example 8 except that the step (3) was not carried out.

### Example 13

A printed wiring board was produced in the same manner as in Example 8 except that the etchant for the step (1) was changed as shown in Table 1. When the material to be etched in this Example was observed through an optical microscope after the end of the step (1), there was observed a pale greenish crystal (water-insoluble reaction product) that adhered to side surfaces of the etched portion.

### Comparative Example 1

A printed wiring board for evaluation was produced in the same manner as in Example 1 except that the step (1) was carried out until a bottom space width of 25 µm was reached and that the step (2) was not carried out.

### Comparative Example 2

A printed wiring board for evaluation was produced in the same manner as in Example 8 except that the etching in the step (1) was carried out until an etching depth of 9 µm (50 % of thickness of an electro-deposited copper foil) was reached.

### Comparative Example 3

An attempt was made to produce a printed wiring board in the same manner as in Example 8 except that the etchant for the step (1) contained no oxalic acid. However, the top space width 1f became too wide before the etching depth reached 16 µm, so that the resist pattern was peeled off the material to be etched. Hence, no printed wiring board for evaluation could be produced. When the material to be etched in this Comparative Example was observed through an optical microscope after the end of the step (1), there was observed no water-insoluble reaction product that adhered to side surfaces of the etched portion.

### Comparative Example 4

A printed wiring board for evaluation was produced in the same manner as in Example 8 except that an etchant having the same composition as that of the etchant for the step (1) was used as an etchant for the step (2).

### <Evaluations>

Each of the printed wiring boards obtained in Examples and Comparative Examples was embedded in an epoxy resin, and embedded products were cut. Their cross sections were polished, and each of the polished cross sections was observed through an optical microscope to measure a top space width 1f of an etched portion. Further, it was observed whether or not a narrowed portion 2a existed. When the narrowed portion 2a existed, its depth d was measured, and the results were classified on the basis of the following three ratings. The depth d refers to a length from a standard line of the upper end portion 2b to a deepest portion 2c (Fig. 2). Table 2 shows the evaluation results.
(A) No narrowed portion 2a is found.
(B) Narrowed portion has a depth of less than 2 µm.
(C) Narrowed portion has a depth of 2 µm or more but less than 3 µm.
(D) Narrowed portion has a depth of 3 µm or more.

Further, each printed wiring board for evaluation was observed through a scanning electron microscope, and side surfaces 1d of a conductor pattern were observed for a state to classify the state on the basis of the following five ratings. Table 2 shows the evaluation results.
(A) The state of side surfaces 1d of a conductor pattern is very smooth.
(B) Smooth.
(C) Slightly roughened.
(D) Roughened.
(E) Greatly roughened.

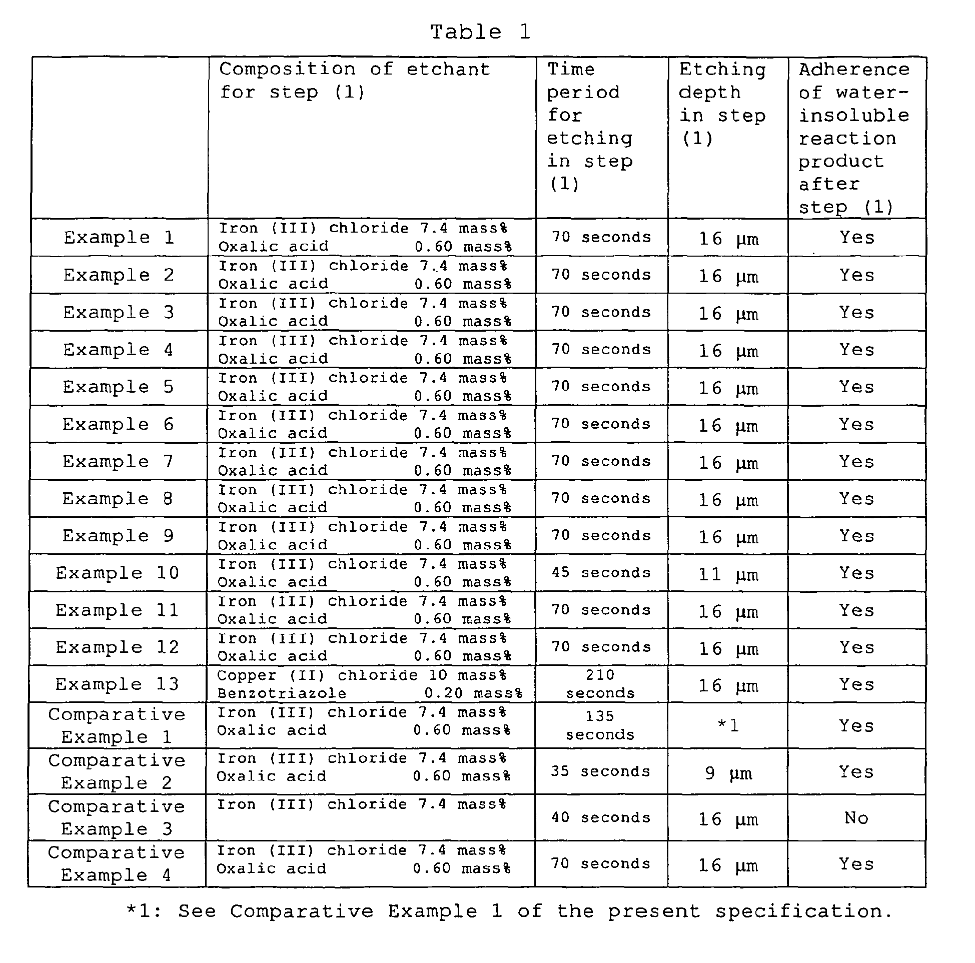

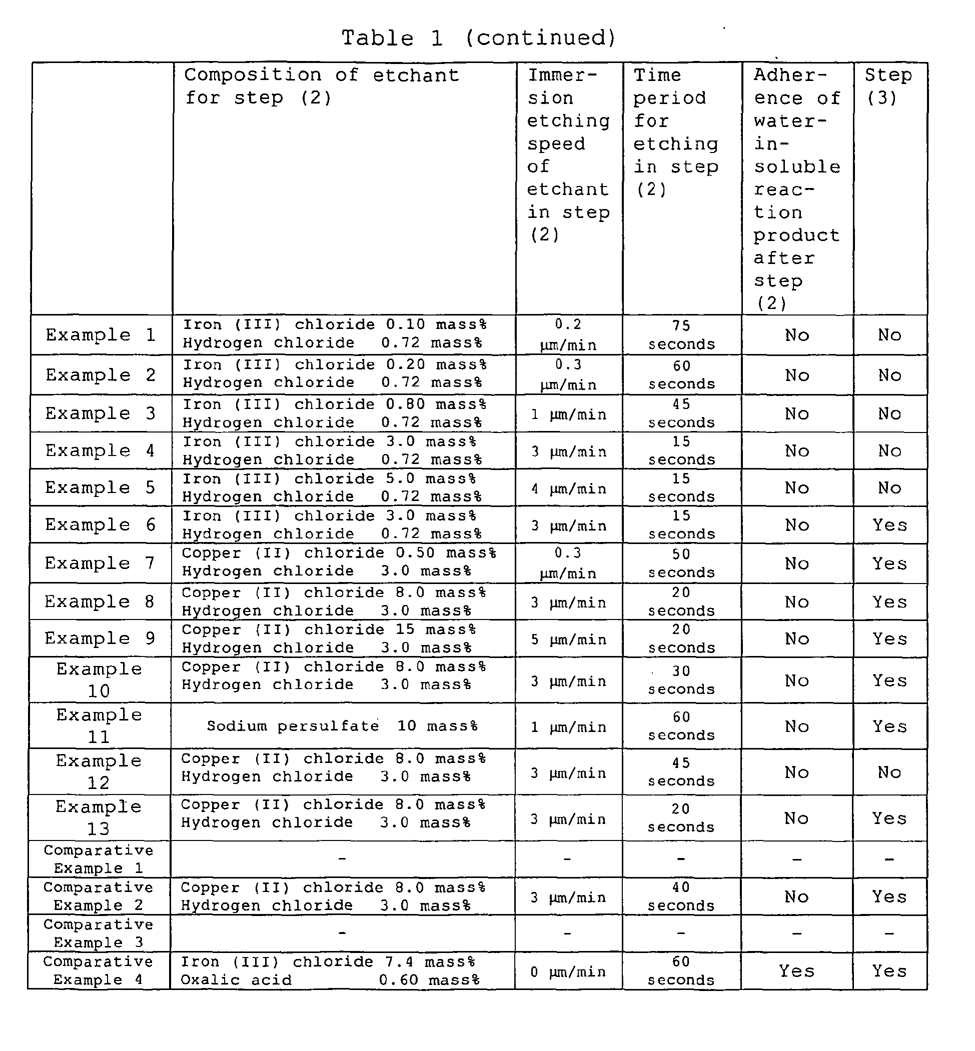

**Table 2**

| | Top space width 1f | Narrowed portion of side surfaces of conductor pattern | Roughening of side surfaces of conductor pattern |
|---|---|---|---|
| Example 1 | 27µm | B | C |
| Example 2 | 27µm | B | B |
| Example 3 | 28µm | B | B |
| Example 4 | 29µm | B | B |
| Example 5 | 32µm | B | B |
| Example 6 | 30µm | A | B |
| Example 7 | 27µm | A | A |
| Example 8 | 28µm | A | A |
| Example 9 | 31µm | A | A |
| Example 10 | 33µm | A | A |
| Example 11 | 35µm | B | B |
| Example 12 | 27µm | C | A |
| Example 13 | 30µm | A | A |
| Comparative Example 1 | 27µm | D | D |
| Comparative Example 2 | 40µm | A | A |
| Comparative Example 3 | - | - | - |
| Comparative Example 4 | 26µm | D | E |

As is seen when Examples and Comparative Examples are compared, there can be obtained cross-sectional forms close to a rectangular form and conductor patterns free of a narrowed portion and roughened surfaces. As is seen when Example 1 and Comparative Example 1 are compared, in Comparative Example that does not carry out the step (2) that is an essential requirement, side surfaces of an etched portion have a narrowed portion and roughening. As is seen when Example 8 and Comparative Example 2 are compared, in Comparative Example 2 in which the etching depth in the step (1) is less than 60 % of a copper foil thickness, the top space width 1f is broad, and the cross-sectional form of the conductor pattern is finally trapezoidal. As is seen from Comparative Example 3, further, when an etchant that does not form a water-insoluble reaction product is used in the step (1), no fine pattern can be formed. Further, also when an etchant that forms a water-insoluble reaction product is used in the step (2) like Comparative Example 4, the side surfaces of a conductor pattern have a narrowed portion and roughening.

As is seen when Examples 1 to 5 are compared, in Example 1 in which the immersion-etching speed is less than 0.3 µm/minute, it is found that the effect of suppressing the surface roughness of sides of a conductor pattern tends to decrease. Further, in Examples 5 and 9 in which the immersion-etching speed is faster than 3 µm/minute, it is found that the top space width 1f tends to increase. Further, in comparison with the etching time period (135 seconds) in Comparative Example 1 in which the etching in the step (1) alone is carried out, the etching time periods in Examples 2 to 12 that are preferred embodiments of this invention are short in spite of the step (1) using the same etchant as that in Comparative Example 1. In particular, the etching time periods in Examples 4 to 6 (total etching time period 85 seconds) and the etching time periods in Examples 8 and 9 (total etching time period 90 seconds) are short.

As is seen when Example 8 and Example 13 are compared, it is seen that in Example 8 in which the etchant used in the step (1) is an etchant containing iron (III) chloride and oxalic acid, there can be obtained a cross-sectional form closer to a rectangular form.

As is seen when Examples 6, 8 and 11 are compared, there can be obtained a cross-sectional form closer to a rectangular form when an etchant containing iron (III) chloride or copper (II) chloride is used as an etchant for use in the step (2). Further, in Examples 7, 8, 9, 10, 12 and 13 that use etchants containing copper (II) chloride as an etchant in the step (2), it is seen that smooth surfaces are obtained.

As is seen in Example 12, when the metal to be etched is copper or copper alloy and when the etchant component used in the step (2) is copper (II) chloride, a narrowed portion 2a is liable to remain on side surfaces of a conductor pattern. However, as is seen in Example 8, when the step (3) is carried out, the narrowed portion can be highly inhibited even in such a case.

In Examples 1 to 9, 11 and 12 where the etching conditions in the step (1) are the same, the immersion-etching speed of the etchant in the step (2) and the etching time period in the step (2) are not in inverse proportion. That is because the ratio of the immersion-etching speed and the etching speed by a spray method differs depending upon the composition of the etchant. Further, the etching speed in the depth direction changes toward a slower speed as the etching proceeds, and the degree of this change differs depending upon the composition of the etchant, which is also one of reasons.

The following Examples 14 to 17 are examples of the second etching method.

### Example 14

### <Preparation of etchant>

Water was added to 11 kg (4.1 kg as an anhydride) of a commercially available 40°Be iron (III) chloride aqueous solution (concentration 37 mass%) and 1.1 kg (0.79 kg as an anhydride) of oxalic acid dihydrate up to a total of 100 kg to prepare an etchant containing 4.1 mass % of iron (III) chloride and 0.79 mass% of oxalic acid.

### <Preparation of material to be etched>

A positive photoresist was applied to both surfaces of a copper-clad laminate obtained by bonding 12 µm thick rolled copper foils (metal layer) to both surfaces of a 160 µm thickness glass epoxy insulating substrate, and it was dried such that a dried resist layer had a thickness of 5 µm each. Evaluation resist patterns having a line width/space width of 15 µm/15 µm each were formed thereon by exposure, development and washing with water, to prepare a material to be etched for an etching test.

### <Step (4)>

The above material to be etched was held horizontally with the surface A facing downward, and the above etchant controlled at a temperature of 30°C was ejected to the material to be etched to etch the surface A. As an etching apparatus, there was used an etching apparatus having a full-cone spray nozzle (trade name: ISJJX20PP, supplied by H. IKEUCHI Co., Ltd.) having a spray nozzle top end 6 cm (z: Fig. 3) below the material to be etched, having an ejection axis on a perpendicular line and having an ejection angle of 65°. The pressure for supplying the etchant to the spray nozzle was set at 200 kPa, the ejection amount was set at 2.0 L/minute (ejection amount per unit area 77 mL/cm²·minute), and 90 seconds after the above etching was started, the ejection of the etchant was stopped. When the material to be etched was observed through an optical microscope after it was washed with water, a pale greenish crystal (water-insoluble reaction product) was observed adhering to side surfaces of the etched portion.

### <Step (5)>

The upper and lower sides of the material to be etched were reversed.

### <Step (6)>

It was held horizontally with the surface B facing downward, and the surface B was etched for 90 seconds under the same conditions as those in the step (4).

### <Post Treatment>

The material of which the etching was completed was immersed in an aqueous sodium hydroxide solution having a concentration of 3.0 mass% for 3 minutes to peel off the resist patterns. Then, hydrochloric acid having a hydrogen chloride concentration of 3.6 mass% was spray-ejected to both sides for 30 seconds each, followed by washing with water and drying, to prepare a printed wiring board for evaluation.

### <Evaluation>

The printed wiring board for evaluation was observed through a digital microscope (trade name: VK-8500: supplied by KEYENCE CORPORATION) to show that the line/space width on the entire surface of each side was in the range of 15 ±2 µm and that no opening of a line, etc., took place.

### Example 15

An etchant containing 4.1 mass% of iron (III) chloride and 2.0 mass% of oxalic acid was prepared in the same manner as in Example 14. Surfaces A and B were etched with the above etchant in the same manner as in Example 14 for 20 minutes each. On each surface, a rolled copper foil in a portion free of a resist pattern was removed in 12 minutes after the ejection of the etchant was started. In this printed wiring board for evaluation, the line/space width on the entire surface of each sides was in the range of 15 ±2 µm, and no opening of a line, etc., was not observed. When the etched material was observed through an optical microscope after washed with water, a pale greenish crystal was observed adhering to side surfaces of the etched portion.

### Example 16

A printed wiring board for evaluation was produced in the same manner as in Example 14 except that the entire etching apparatus was tilted at 10° from the horizontal in the step (4) and the step (6). In this case, the material to be etched, the nozzle and the ejection axis thereof had the same positional relationship as that in Example 14. On each surface, the line/space width of a portion etched in the highest position was 15 µm ±2 µm/15 µm ±2 µm, and the line/space width of a portion etched in the lowest position was 16 µm ±2 µm/14 µm ±2 µm.

### Example 17

A printed wiring board for evaluation was prepared in the same manner as in Example 16 except that the entire etching apparatus was tilted at 20° from the horizontal.

On each surface, the line/space width of a portion etched in the highest position was 15 µm ±2 µm/15 µm ±2 µm, and the line/space width of a portion etched in the lowest position was 18 µm ±2 µm/12 µm ±2 µm.

### Comparative Example 5

A printed wiring board for evaluation was produced in the same manner as in Example 14 except that the etchant contained no oxalic acid and that the time period of the ejection of the etchant on each surface was set for 45 seconds. In this printed wiring board for evaluation, while the surface B was etched in the step (6), the etching of the surface A proceeded to excess, and the line/space width was in the range of 9 µm ±3 µm/21 µm ±3 µm although it differed depending upon where it was measured. Further, a line/space width of approximately 15 µm/15 µm was obtained in a most part of the surface B. However, there was observed the existence of some portions where the line width was narrower than 6 µm (2/5 of the target value), or the line was open due to overetch because of contact to the etchant during the etching of the surface A. Further, when the etched material was observed through an optical microscope after washed with water, no water-insoluble substance was observed adhering to side surfaces of an etched portion.

### Comparative Example 6

A Printed wiring board was produced in the same manner as in Comparative Example 5 except that the material to be etched was washed with water between the step (4) and the step (6). This printed wiring board for evaluation had a line/space width of approximately 15 µm/15 µm on a surface on each side. However, both surfaces were locally etched to excess, and the line width was observed being partly smaller than 10 µm (2/3 of the target value), or lines were observed being opened in extreme sites.

### Comparative Example 7

A printed wiring board for evaluation was produced in the same manner as in Example 14 except that the composition of the etchant was changed to a composition containing 4.1 mass% of iron (III) chloride and 0.16 mass% of oxalic acid and that the time periods for ejecting the etchants in the steps (4) and (6) were set for 80 seconds each. Copper foil on a pattern-free area on each surface was removed in 60 seconds after the ejection of the etchant was started. In this printed wiring board for evaluation, the etching on the surface A proceeded to excess while the surface B was etched, and the line/space width was in the range of 12 ±3 µm/18 ±3 µm although it differs depending upon measurement sites. Further, most part of the surface B had a line/space width of 15 µm ±3 µm/15 µm ±3 µm, while the surface B was etched to excess since the etchant contacted thereto during the etching of the surface A, and it was observed that there were hence partly portions having a line width of smaller than 6 µm (2/5 of the target value). Further, when the etched material was observed through an optical microscope after it was washed with water, no water-insoluble reaction product was observed adhering to side surfaces of an etched portion.

### Comparative Example 8

A printed wiring board for evaluation was produced in the same manner as in Example 16 except that the tilting angle of the etching apparatus was set at 30°. On each surface, the line/space width of a portion etched in the highest position was 15 µm ±3 µm/15 µm ±3 µm in the highest position, while a portion etched in the lowest position had copper still remaining in a space portion.

### Comparative Example 9

A printed wiring board for evaluation was produced in the same manner as in Comparative Example 8 except that the time period for ejection of the etchant was set for 300 seconds. On each surface, the line/space width of a portion etched in the lowest position was 15 µm ±3 µm/15 µm ±3 µm, while the etching proceeded to excess in a portion etched in the highest position, and the line/space width in that portion was 9 µm ±3 µm/21 µm ±3 µm.

By this invention, a printed wiring board having fine conductor patterns on both surfaces thereof can be produced by a simple method as shown in Examples 14 to 17. As shown in Comparative Examples 5 to 7, when the etchant that does not form a water-insoluble reaction product, which etchant is an essential requirement for the second etching method, is not used, the etching that is not intended proceeds locally due to the etchant that moves around onto the upper surface, and hence there cannot be produced any printed wiring board having a fine wiring pitch by such simple steps as those which are used in this invention. As shown in Comparative Examples 8 and 9, when the material to be etched is not held at an angle of 20° or less from the horizontal, an in-plane variability takes place on the finish of etching, and hence there cannot be produced any printed wiring board having a fine wiring pitch by such simple steps as those which are used in this invention.

### Industrial Utility

The etching method of this invention can be suitably used not only in the production of printed wiring boards but also in various other industrial fields where the highly controlled etching of copper or copper alloy is required for the production of lead frames, precision gears, precision flat springs, discs and stripes for encoders, various stencils, etc..

## Claims

1. An etching method for etching a material to be etched prepared by forming a resist pattern on a metal layer containing a metal to be etched, the method comprising consecutively carrying out the steps of (1) ejecting an etchant that reacts with the metal to be etched to form a water-insoluble reaction product, by means of a spray nozzle, to perform etching until the etching depth reaches 60 % or more of the metal layer thickness, and (2) ejecting an etchant that does not form a water-insoluble reaction product through a reaction with the metal to be etched, by means of a spray nozzle, to perform etching.

2. The etching method of claim 1, wherein an etching speed is 0.3 µm/minute or more but 3 µm/minute or less when the metal to be etched is immersion-etched with the etchant used in the step (2).

3. The etching method of claim 1, wherein the metal to be etched is copper or copper alloy and the etchant used in the step (1) is an etchant containing iron (III) chloride and oxalic acid.

4. The etching method of claim 1 or 2, wherein the metal to be etched is copper or copper alloy and the etchant used in the step (2) is an etchant containing iron (III) chloride or copper (II) chloride.

5. The etching method of claim 1, wherein the step (3) of removing said water-insoluble reaction product by using a liquid that dissolves the above water-insoluble reaction product is carried out between the step (1) and the step (2).

6. The etching method of claim 5, wherein the metal to be etched is copper or copper alloy and the etchant used in the step (2) is an etchant containing copper (II) chloride.

7. An etching method for etching a material to be etched which material is obtained by stacking metal layers each containing a metal to be etched on both surfaces of an insulating material and forming resist patterns on the metal layers, the method comprising consecutively carrying out the three steps of (4) holding the material to be etched horizontally or at an angle of 20° or less from the horizontal and ejecting an etchant containing a compound that reacts with the metal to be etched to form a water-insoluble reaction product, by means of a spray nozzle from below the material to be etched, to etch one surface (surface A) of the material to be etched, (5) reversing the upper and lower sides of the material to be etched, and (6) holding the material to be etched horizontally or at an angle of 20° or less from the horizontal and ejecting the etchant containing a compound that reacts with the metal to be etched to form a water-insoluble reaction product, by means of a spray nozzle from below the material to be etched, to etch that surface (surface B) which is opposite to the surface (A).

8. The etching method of claim 7, wherein the metal to be etched is copper or copper alloy and the etchant containing a compound that reacts with the metal to be etched to form a water-insoluble reaction product is an etchant containing iron (III) chloride and oxalic acid.

9. The etching method of claim 7, wherein the step (7) of removing said water-insoluble reaction product with a liquid that dissolves said water-insoluble reaction product is carried out between the step (4) and the step (6).
